# FASCICULE DE BREVET EUROPEEN

(11) **EP 0 881 682 B1**
(45) Date de publication et mention de la délivrance du brevet: **28.01.2009**
(21) Numéro de dépôt: 98410057.8
(22) Date de dépôt: 22.05.1998
(51) Int. Cl.: H01L 27/07, H01L 29/78, H02H 9/04

(54) **Dispositif de protection contre des surtensions d'un transistor MOS de puissance intégré**
Hochspannungsschutzanordnung für einen integrierten MOS-Leistungstransistor
Overvoltage protection device for an integrated MOS power transistor

(30) Priorité: 28.05.1997 FR 9706823
(43) Date de publication de la demande: 02.12.1998
(73) Titulaire: STMicroelectronics S.A., 92120 Montrouge (FR)
(72) Inventeur: Barret, Jean, 13510 Eguilles (FR)
(74) Mandataire: de Beaumont, Michel

(56) Documents cités:
- EP-A- 0 622 849
- DE-A- 4 122 347
- US-A- 5 543 645

## Description

La présente invention concerne les composants associant dans un même substrat des transistors MOS de puissance verticaux de type diffusé (VDMOS) et des circuits logiques.

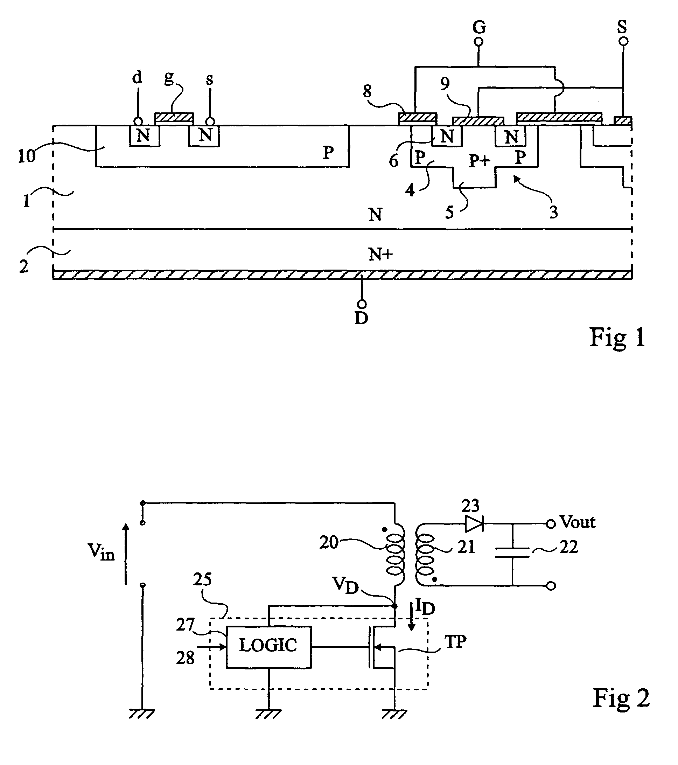

La figure 1 représente très schématiquement une portion d'un tel composant. Celui-ci comprend un substrat de type N généralement constitué d'une couche épitaxiée 1 de type N formée sur un substrat 2 de type N⁺. Dans la partie droite est formé un transistor de puissance et dans la partie gauche un caisson logique.

Le transistor de puissance comporte un ensemble de cellules identiques connectées les unes aux autres, telles que la cellule 3. Chaque cellule comprend un caisson 4 de type P dont la partie centrale 5 est plus fortement dopée. Dans la partie supérieure du caisson, est formé un anneau 6 de type N. La partie séparant la périphérie externe de l'anneau de type N de la périphérie externe du caisson de type P est revêtue d'une grille isolée 8 et l'anneau 6 de type N ainsi que la partie centrale 5 du caisson sont revêtus d'une métallisation 9. Toutes les grilles 8 sont connectées à une borne de grille G et toutes les métallisations 9 sont reliées à une borne de source S. La face arrière de la structure est revêtue d'une métallisation de drain D. Ainsi, quand un signal de grille est appliqué, un courant est susceptible de s'écouler de la borne D à la borne S depuis les régions N 1 et 2 vers les régions N 6, en passant par un canal formé sous les grilles isolées. Cette structure est généralement utilisée de sorte que le drain est polarisé à un potentiel positif par rapport à la source.

Bien que l'on ait mentionné ci-dessus des "cellules" identiques, le transistor de puissance peut avoir une structure digitée. Les régions 6 ne sont alors pas des "anneaux". On conservera néanmoins ce vocabulaire ci-après pour simplifier l'exposé.

Des circuits logiques sont formés dans un ou plusieurs caissons 10. On a représenté dans un caisson 10 un transistor MOS élémentaire ayant des bornes de drain, de source et de grille g, d et s. Ceci ne constitue qu'un exemple de composant susceptible d'être formé dans un caisson logique.

Dans certaines applications, une forte surtension positive est susceptible d'exister entre le drain et la source alors que le transistor MOS de puissance est bloqué, ou pendant une phase de commutation à l'ouverture. Une telle surtension est susceptible de faire claquer en inverse la jonction entre le substrat 1 et le caisson 10 et d'entraîner la destruction de composants logiques formés dans ce caisson. Pour éviter ce phénomène, il est connu, quand une telle surtension apparaît, de remettre en route momentanément le transistor de puissance pour écouler la surtension à travers ce transistor de puissance. Toutefois, les solutions connues présentent divers inconvénients qui vont être exposés ci-après.

La figure 2 représente un exemple de circuit d'alimentation à découpage dans lequel une surtension est susceptible de se produire sur un transistor de puissance. Une tension d'entrée Vᵢₙ est appliquée au primaire 20 d'un transformateur dont le secondaire 21 est relié à un condensateur 22 par l'intermédiaire d'une diode 23. Une tension de sortie Vₒᵤₜ est disponible aux bornes du condensateur 22. La deuxième borne du primaire 20 est reliée à la masse de l'alimentation par l'intermédiaire d'un composant intégré comprenant un transistor MOS de puissance vertical TP et un circuit logique 27. Ce circuit logique comprend notamment une borne reliée à la borne de drain du transistor de puissance, correspondant à la face arrière du composant de la figure 1, une borne reliée à la masse et au moins une borne d'entrée 28 recevant des signaux de commande. Ce circuit logique 27 est notamment destiné à commander la grille du transistor de puissance.

Le fonctionnement d'une alimentation à découpage est bien connu de l'homme de l'art. Il consiste à commuter périodiquement le transistor de puissance TP.

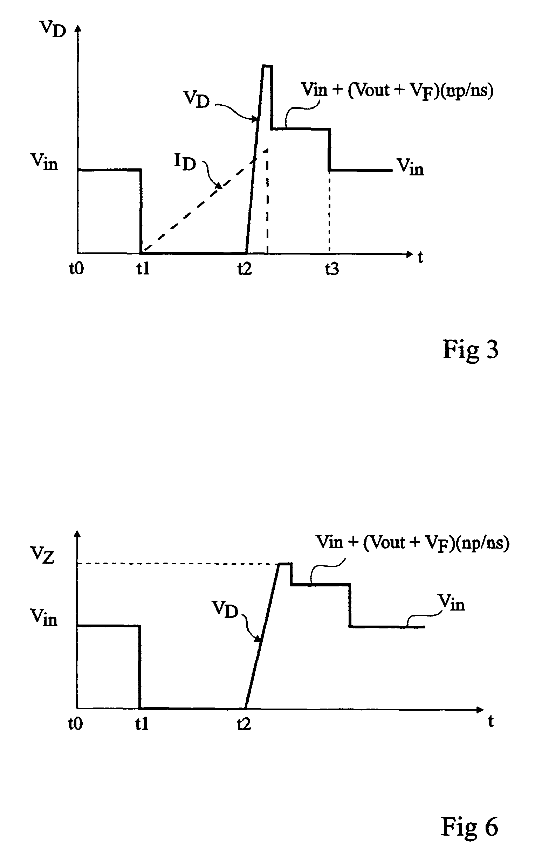

Le fonctionnement à la commutation de ce transistor de puissance va être décrit en relation avec la figure 3 qui représente en fonction du temps, la tension de drain VD du transistor de puissance et le courant ID traversant l'ensemble du composant.

Dans une période initiale, entre les instants t0 et t1, le transistor de puissance est bloqué et la tension à ses bornes est égale à la tension Vᵢₙ. Ensuite, on a rendu le transistor de puissance passant jusqu'à un instant t2, et à cet instant t2, on veut bloquer à nouveau le transistor de puissance. Normalement, la tension aux bornes de ce composant croît jusqu'à une valeur Vᵢₙ+(Vₒᵤₜ+V_{F})(np/ns) où Vin désigne la tension au primaire du transformateur, Vₒᵤₜ la tension au secondaire du transformateur, V_{F} la chute de tension en direct de la diode 23, et np/ns le rapport de transformation du transformateur. Ensuite, à un instant t3, une fois que le transformateur est démagnétisé, la tension chute à la valeur Vᵢₙ.

Un problème qui se produit souvent est que le transformateur présente une certaine inductance parasite, liée à ce transformateur ou à ses fils de connexion, et que, juste après l'instant t2, apparaît une forte surtension. Comme le transistor de puissance est alors dans une phase de blocage, cette surtension tend à produire un courant dans la partie la plus fragile du composant, c'est-à-dire à travers la jonction entre le substrat et le caisson logique. Cette surcharge peut être destructrice comme on l'a indiqué précédemment.

Pour résoudre ce problème, de nombreuses solutions ont été prévues dans l'art antérieur. Certaines d'entre elles, prévoient l'utilisation de condensateurs aux bornes de l'enroulement primaire ou aux bornes du composant de puissance pour lisser la surtension. Ces solutions présentent l'inconvénient de nécessiter des composants extérieurs et de ralentir la commutation, et donc d'augmenter les pertes joules dans le composant. Une autre solution a consisté à disposer une diode Zener en parallèle sur le composant de puissance pour absorber la surcharge mais, à nouveau, ceci nécessite l'utilisation d'un composant extérieur. Eventuellement, cette diode Zener a été intégrée dans la structure monolithique incluant le composant de puissance et son circuit logique mais il faut alors utiliser une diode Zener de relativement grande dimension et cela est coûteux en surface de silicium.

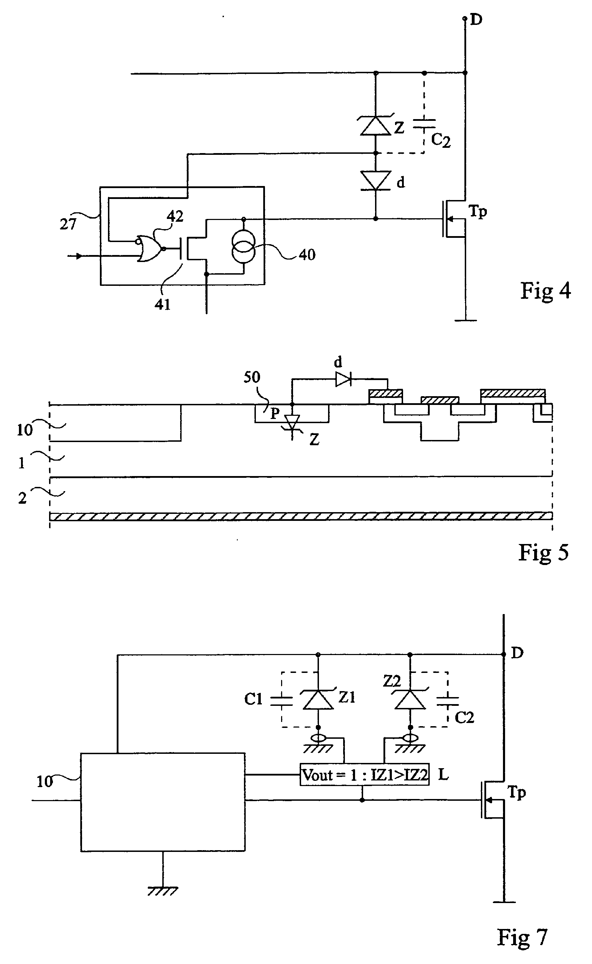

On a alors proposé la solution illustrée en figure 4 qui consiste à utiliser une diode Zener Z ayant un seuil de protection inférieur au seuil de destruction du transistor de puissance TP et connectée de sorte que sa mise en conduction entraînant la mise en conduction du transistor de puissance. A titre d'exemple, le circuit de commande du transistor de puissance TP peut comprendre une source de courant 40 connectée entre grille et source du transistor TP, et un transistor MOS 41 en parallèle sur cette source et susceptible de la court-circuiter quand on veut ouvrir le transistor de puissance TP. Une diode Zener Z en série avec une diode de redressement d est connectée entre drain et grille du transistor de puissance. Le point de connexion des diodes Z et d est connecté à la grille du transistor 41 par l'intermédiaire d'un circuit logique 42 pour ouvrir ce transistor quand la diode Zener devient passante à la suite d'une surtension. Ce circuit de commande ne sera pas décrit en détail car il ne constitue qu'un exemple d'une possibilité de commande de remise en conduction par une diode Zener Z détectant la tension de drain d'un transistor de puissance.

En pratique, comme le représente la figure 5, la diode Zener Z est constituée d'une région 50 de type P formé dans le substrat 1. Une métallisation d'anode de cette diode Zener est reliée à la grille du transistor de puissance par l'intermédiaire d'une diode d. Bien entendu, cette diode d sera en pratique de préférence intégrée parmi les composants du circuit logique contenu dans le caisson 10.

Ce mode de réalisation présente toutefois un inconvénient illustré en relation avec la figure 6 qui représente la tension VD sur le drain du transistor MOS de puissance TP. Comme précédemment, on considère que le transistor TP est ouvert entre les instants t0 et t1 puis que l'on cherche à le rebloquer à un instant t2. Alors, la tension sur le drain croît jusqu'à la tension V_{Z}, puis le composant de puissance est remis en conduction pour limiter la tension à ses bornes à cette valeur V_{Z}. On retrouve alors les phases décrites précédemment en relation avec la figure 3. La variation rapide de la tension aux bornes du transistor TP crée un courant capacitif à l'intérieur de la diode Zener Z. Ce courant tend à recharger la grille du transistor TP et donc à réduire la vitesse de blocage.

L'inconvénient est que la pente de la tension VD pendant la phase de blocage est beaucoup plus faible que précédemment, c'est-à-dire que la durée de blocage est plus longue et donc que les pertes augmentent. Ceci est bien entendu un inconvénient quand on veut réaliser une alimentation à découpage à temps de réponse aussi rapide que possible. Cette augmentation de la pente est due à ce qu'il existe une capacité parasite C aux bornes de la diode Zener Z, cette capacité parasite étant représenté en pointillés en figure 4.

Un objet de la présente invention est d'assurer une protection d'un composant incluant un transistor MOS de puissance vertical et un circuit logique, contre des surtensions sur le drain, en évitant de ralentir la vitesse de commutation du transistor de puissance.

Pour atteindre cet objet, la présente invention prévoit un dispositif de protection selon la revendication 1.

Selon un mode de réalisation de la présente invention, la tension d'avalanche de la deuxième diode Zener est sensiblement égale à la tension de claquage du composant.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un exemple de composant auquel s'applique la présente invention ;
la figure 2 représente un exemple de montage du composant de la figure 1 ;
la figure 3 représente des courbes de tension et de courant dans le circuit de la figure 2 ;
la figure 4 représente une variante d'une partie du circuit de la figure 2 ;
la figure 5 représente une variante de composant de la figure 1 incluant la variante de circuit de la figure 4, selon l'art antérieur ;
la figure 6 représente des courbes de tension et de courant correspondant à la variante des figures 4 et 5 ; et
la figure 7 représente un circuit de protection selon la présente invention.

Dans ces diverses figures, de mêmes éléments sont désignés par de mêmes références. Par ailleurs, dans les diverses vues en coupe de composants semiconducteurs, conformément à l'usage, les diverses dimensions ne sont pas tracées à l'échelle mais arbitrairement dilatées pour faciliter la lisibilité des figures.

La présente invention vise, comme les structures de l'art antérieur décrites en relation avec les figures 4 à 6 à provoquer un redéclenchement du transistor de puissance d'un composant incluant un transistor MOS vertical de puissance et un circuit logique quand ce composant est soumis à une forte surtension. Ainsi, comme précédemment, il est prévu de détecter une tension de protection peu inférieure à la tension de claquage du composant et de provoquer la remise en conduction du transistor de puissance TP dès que cette tension de protection est atteinte.

La présente invention prévoit de réaliser la détection en connectant au drain D du transistor de puissance TP deux diodes Zener Z1 et Z2 et plus particulièrement, dans le cas décrit précédemment où le drain est de type N, les cathodes de diodes Zener. Les anodes des diodes Zener Z1 et Z2 sont connectées par l'intermédiaire d'un circuit logique L, fournissant un signal propre à permettre un redéclenchement du transistor de puissance quand la tension dépasse le seuil d'une des diodes Zener. Plus particulièrement, on choisit l'une des diodes Zener, par exemple la diode Zener Z1, pour que sa tension d'avalanche soit égale à la tension de protection visée. La deuxième diode Zener, Z2, aura une tension d'avalanche plus élevée, par exemple la même tension d'avalanche que le caisson des composants logiques.

Le circuit logique L assure les fonctions suivantes : il ne fournit aucun signal de sortie quand ses deux entrées sont égales et fournit un signal de sortie dès que l'une de ses entrées est haute et plus élevée que son autre entrée. Ce circuit logique compare les courants qui traversent les diodes Zener Z1 et Z2. Lorsque le courant de la diode Z1 est plus élevé que celui de la diode Z2, le circuit L fournit un signal de remise en conduction du transistor de puissance TP. En fait, le circuit logique L sera incorporé dans le caisson logique 10 et a été représenté à l'extérieur seulement pour la simplicité de la description de la figure.

Chacune des diodes Zener Z1 et Z2 peut par exemple être réalisée comme la diode Zener Z illustrée en figure 5, c'est-à-dire qu'elle est constituée d'une région P formée dans le caisson 1. Ces diodes Zener auront une même surface pour présenter des capacités parasites C1 et C2 identiques et des tensions d'avalanche distinctes, ce qui peut être obtenu par exemple en prévoyant que la région P de l'une des diodes Zener est plus dopée ou plus profonde que l'autre. Ainsi, au début de la phase de commutation du composant, après l'instant t2 de la figure 3 ou 6, les tensions d'anode des deux diodes Zener croissent simultanément sous l'effet de leur capacité parasite mais ces tensions ne sont pas répercutées vers le circuit de commande puisque le circuit logique L ne fournit aucune sortie quand ses deux entrées sont égales. Le temps de montée de la tension aux bornes du composant sera donc le même que celui de la figure 3 et ne sera pas ralenti comme dans le cas de la figure 6. C'est seulement quand la diode Zener de plus petit seuil d'avalanche (correspondant au seuil de protection) entre en conduction que le dispositif entre en action de façon similaire à ce qui a été décrit en relation avec la figure 6. On obtient donc les avantages de la protection intégrée décrite en relation avec les figures 4, 5 et 6 sans l'inconvénient du ralentissement du temps de commutation à l'ouverture.

Bien entendu, de nombreuses variantes de réalisation du circuit logique L, et du mode de connexion de ce circuit à la grille du transistor de puissance, pourront être envisagées par l'homme de l'art.

En ce qui concerne la réalisation des diodes Zener Z1 et Z2, on pourra avantageusement utiliser des diodes Zener formées à partir d'éléments similaires aux caissons du transistor MOS de puissance, comme cela est décrit dans le brevet des Etats-Unis d'Amérique N° 5 543 645. Le seul impératif est que ces deux diodes Zener aient des tensions de seuil distinctes et des capacités parasites sensiblement égales.

## Revendications

1. Dispositif de protection d'un composant comprenant un substrat (1, 2) d'un premier type de conductivité, dans lequel sont disposés un transistor MOS de puissance vertical (TP) et des composants logiques, le substrat correspondant au drain du transistor MOS et les composants logiques étant formés dans au moins un caisson (10) d'un deuxième type de conductivité opposé au premier type et du côté de la face supérieure du substrat, le dispositif comprenant une diode Zener (Z1) dont une première borne correspond au substrat et une deuxième borne à une région du deuxième type de conductivité formée dans le substrat,
le dispositif comprenant en outre une deuxième diode Zener (Z2) dont une première borne correspondant à une région du même type de conductivité que le substrat est connecté à celui-ci, de même surface que la première diode Zener mais de tension d'avalanche plus élevée, les deuxièmes bornes des deux diodes Zener étant connectées à un circuit de déclenchement du transistor de puissance par l'intermédiaire d'un circuit logique (L) ne devenant passant que quand l'une de ses entrées est haute et distincte de l'autre entrée.

2. Dispositif selon la revendication 1, **caractérisé en ce que** la tension d'avalanche de la deuxième diode Zener est sensiblement égale à la tension de claquage du composant.

## Claims

1. A protection device for a component including a substrate (1, 2) of a first conductivity type in which are disposed a vertical MOS power transistor (TP) and logic components, the substrate corresponding to the drain of the MOS transistor and the logic components being formed in at least one well (10) of a second conductivity type opposite to the first conductivity type and on the upper surface side of the substrate, the device including a Zener diode (Z1), a first terminal of which corresponds to the substrate and a second terminal of which corresponds to a region of the second type of conductivity formed in the substrate,
the device further including a second Zener diode (Z2) having a first terminal corresponding to a region of the same conductivity type as the substrate and connected thereto, having the same surface as the first Zener diode but an higher avalanche voltage, the second terminals of both Zener diodes being connected to a circuit for triggering the power transistor through a logic circuit (L) which only becomes conductive when one of its inputs is high and distinct from the other input.

2. The device of claim 1, **characterized in that** the avalanche voltage of the second Zener diode is substantially equal to the breakdown voltage of the component.

## Patentansprüche

1. Schutzvorrichtung für ein Bauteil mit einem Substrat (1,2) eines ersten Leitfähigkeitstyps, in welchem ein vertikaler Leistungs-MOS-Transistor (TP) und Logikbauteile angeordnet sind, wobei das Substrat dem Drainbereich des MOS-Transistors entspricht und die Logikbauteile in wenigstens einem Graben (10) eines dem ersten Leitfähigkeitstyp entgegengesetzten zweiten Leit-fähigkeitstyps und an der Oberseite des Substrats ausgebildet sind, wobei die Vorrich-tung eine Zenerdiode (Z1) umfasst, von welcher ein erster Anschluß dem Substrat und ein zweiter Anschluß einem in dem Substrat ausgebildeten Bereich des zweiten Leitfähigkeitstyps entspricht,
und wobei die Vorrichtung des weiteren eine zweite Zenerdiode (Z2) umfasst, von welcher ein erster Anschluß einem Bereich desselben Leitfähigkeitstyps wie das Substrat entspricht und mit diesem verbunden ist, wobei die zweite Zenerdiode oberflächengleich mit der ersten Zener-diode ist, jedoch eine höhere Lawinendurchbruchspannung besitzt und die zweiten Anschlüsse der beiden Zenerdioden mit einer Auslöse- bzw. Triggerschaltung des Leistungstransistors über eine Logikschaltung ( L ) verbunden sind, die nur leitend wird, wenn der eine ihrer Eingänge sich auf hohem und von dem anderen Eingang verschiedenen Potential befindet.

2. Vorrichtung nach Anspruch 1, **dadurch gekennzeichnet, dass** die Lawinendurch-bruchspannung der zweiten Zenerdiode im wesentlichen gleich der Durchbruchspannung des Bauteils ist.
